# EUROPEAN PATENT APPLICATION

(11) **EP 2 025 699 A1**
(43) Date of publication of application: **18.02.2009**
(21) Application number: 07790582.6
(22) Date of filing: 11.07.2007
(51) Int. Cl.: C08G 77/04

(54) **ORGANIC-INORGANIC HYBRID GLASSY MATERIAL AND ITS FABRICATION METHOD**

(30) Priority: 14.07.2006 JP 2006194610; 14.07.2006 JP 2006194609
(71) Applicant: Central Glass Co., Ltd., Ube-shi, Yamaguchi 755-0001 (JP)
(72) Inventor: KUNIYOSHI, Minoru c/o CENTRAL GLASS COMPANY LIMITED, Mie 515-0001 (JP); YOKO, Toshinobu, Kyoto 611-0013 (JP); TAKAHASHI, Masahide, Kyoto-shi, Kyoto 600-8171 (JP)
(74) Representative: Manitz, Finsterwald & Partner GbR
(86) International application number: PCT/JP2007/063778
(87) International publication number: WO 2008/007681

(57) **Abstract**

Disclosed is an organic-inorganic hybrid glassy material **characterized in that** change ofAbbe number does not exceed 1.5 in a temperature range of 20-150°C (a difference between the maximum value and the minimum value is 1.5 or less). This organic-inorganic hybrid glassy material may have a characteristic that transmittance in a wavelength range of 300-800nm is not lowered by 5% or greater to a laser light irradiation of a wavelength of 330-380nm.

## Description

### TECHNICAL FIELD

The present invention relates to an organic-inorganic hybrid glassy material, where raw materials used in a sol-gel process are starting materials, and also to processes for producing the same.

With regard to materials which soften at not higher than 600°C, polymer materials, low-melting glass, etc. have been famous and, for a long time, they have been used in many areas such as sealing and encapsulating materials, passivation glass, glaze, etc. Since their physical properties are different between polymer materials and low-melting glass, they have been used differently depending upon the environment in which they are used.
In general, in case that heat resistance and airtight property have a priority, glass has been used, while, in the field where characteristics other than heat resistance and airtight property have a priority, organic materials represented by polymer materials have been used. However, as a result of recent progress in the art, characteristics that have not been demanded up to now have received attention, and development of materials having such characteristics has been expected.

In view of the above, development for polymer materials where heat resistance and airtight property are enhanced and for glass where a softening temperature region is made low or so-called low-melting glass has been positively carried out. Particularly in the market of electronic materials where heat resistance and airtight property are demanded, low-melting glass represented by a PbO-SiO₂-B₂O₃ series or PbO-P₂O₅-SnF₂ series glass has been a material which is indispensable in the field of sealing, coating, etc. of electronic parts. In addition, energy required for molding process or, in other words, the cost can be reduced in low-melting glass as compared with high melting point glass, and therefore that meets the recent social demand for conservation of energy. Further, when it can be melted at the temperature at which an organic material having optical function property is not destructed, its application as a host for (non-linear) optical material containing an optically functioning organic material to optical information communication devices such as optical switch is expected. As such, there has been a demand in many fields for materials having heat resistance and airtight property, which are characteristics of common melted glass, and also being apt to have various characteristics as in the case of polymer materials and, especially, the expectation is concentrated to low-melting glass. Furthermore, an organic-inorganic hybrid glass has been also receiving public attention as one of the low-melting glass.

With regard to the low-melting glass, for example, Tick glass represented by glass of an Sn-Pb-P-F-O type (refer to, for example, Non-Patent Publication 1) is famous, and, since it has a glass transition point at around 100°C and also has an excellent water resistance, it has been used in some of the market. However, in this low-melting glass, since lead is contained in its main constituting components, there has been a necessity to use an alternative material due to the recent trend of environmental protection. In addition, demanded characteristic to Tick glass has been greatly changed and, at the same time, the demand as such has been diversified as well.

With regard to common methods for the production of glass, a melting method and a low-temperature synthesis method have been known. Melting method is a method where glass materials are directly heated to melt and make them into glass. Many kinds of glass are produced by this method and a low-melting glass is also produced by this method. In the case of a low-melting glass, however, there are many restrictions for glass composition that can be constituted such as that the containment of lead, alkali, bismuth, etc. is necessary for lowering its melting point.

On the other hand, with regard to a low-temperature synthesis method for noncrystalline bulks, there are sol-gel process, liquid-phase reaction method and nonaqueous acid-base reaction method. In a sol-gel process, a metal alkoxide or the like is subjected to a hydrolysis-polycondensation and subjected to a thermal treatment at the temperature of higher than 500°C (refer to, for example, Non-Patent Publication 2), usually at 700 to 1,600°C, whereby a bulk can be produced. However, when the bulk produced by a sol-gel process is considered as a material for practical use, there have been many cases where the product becomes porous, due to decomposition and burning of organic materials, such as alcohol, which are introduced in the preparation of the starting solution, or evaporation and release, etc. of decomposition gas of organic materials or heating process of water. Thus, there has been a problem in terms of heat resistance and airtight property. As such, in the production of bulk by a sol-gel process, many problems have been still left unsolved, and particularly production of low-melting glass by a sol-gel process has not been carried out.

Furthermore, a liquid-phase reaction method has a low productivity because of its low yield, and in addition it uses hydrofluoric acid or the like in its reaction system and is limited for the synthesis of a thin film at best. Accordingly, it is almost impossible to use it as a practical means for the synthesis of bulks.

A nonaqueous acid-base reaction method is a means which has been developed recently and, although it is able to produce an organic-inorganic hybrid glass which is one of the low-melting glasses (refer to, for example, Non-Patent Publication 3), it is still in a stage of development and all kinds of low-melting glasses cannot be produced by that.

Accordingly, the production of many kinds of low-melting glasses has been carried out not by a low-temperature synthesis method but by a melting method. Therefore, due to melting of glass materials, the glass composition thereof is limited, and, with regard to a low-melting glass that can be produced, the type thereof has been very limited.

Incidentally, at present, a low-melting glass is prominent as a material in view of heat resistance and airtight property, and it is often that the required physical property is demanded in a form of being represented by the low-melting glass. However, the material is not limited to a low-melting glass. If the required physical property is satisfied, there is no large problem in low-melting or low-softening material other than glass.

In other words, hitherto, there have not been materials that have softening points lower than those of current low-melting glasses, do not contain lead, have chemical durability, and are transparent.

In the publicly known art, there have been known a process for producing silica glass fibers by a sol-gel process (refer to, for example, Patent Publication 1), a process for producing titanium oxide fibers by a sol-gel process (refer to, for example, Patent Publication 2), and a process for producing a semiconductor doped matrix by a sol-gel process (refer to, for example, Patent Publication 3). There has been also disclosed a P₂O₅-TeO₂-ZnF₂ series low-melting glass by a melting method (refer to, for example, Patent Publication 4).
Patent Publication 1: Japanese Patent Application Publication 62-297236 A
Patent Publication 2: Japanese Patent Application Publication 62-223323 A
Patent Publication 3: Japanese Patent Application Publication 1-183438 A
Patent Publication 4: Japanese Patent Application Publication 7-126035 A
Non-Patent Publication 1: P. A. Tick, Physics and Chemistry of Glasses, Vol. 25, No. 6, pp. 149-154 (1984).
Non-Patent Publication 2: K. Kamiya, S. Sakka and N. Tashiro, Yogyo Kyokaishi, pp.614-618, 84 (1976).
Non-Patent Publication 3: M. Takahashi, H. Niida and T. Yoko, New Glass, pp.8-13, 17 (2002)

### SUMMARY OF THE INVENTION

The production of many low-softening materials, particularly low-melting glasses, has been carried out by a melting method. Therefore, there are many restrictions for their glass compositions and, in view of melting materials for the glass raw material, a low-melting glass that can be produced has been very limited.

On the other hand, when the production is carried out by a sol-gel process, which is a low-temperature synthesis method, a treatment temperature of not lower than 500°C is necessary for densification.
However, when the treatment is conducted at such temperature, a low-melting glass is not produced. Therefore, as a result, it has not been possible to produce a low-melting glass having good heat resistance and good airtight property. Particularly, in the field of electronic materials, there have not been found low-melting glasses or low-melting materials other than glass, which cope with severe heat resistance, airtight property and UV resistance and with the production of low-melting ones.

The methods that are disclosed in the above JP-A-62-297236, JP-A-62-223323 and JP-A-1-183438 have achievements that the material production, which had been able to be met only by high-temperature melting, was made possible even at low temperature. They, however, cannot produce low-melting glass. It is also necessary to have a treatment at not lower than 500°C after the sol-gel treatment. On the other hand, in a method of JP-A-7-126035, it is disclosed that a glass having a transition point of three hundred and several tens degrees centigrade can be produced. However, there has been no example up to now for the production of a glass having a transition point lower than that without a material for making the melting point low, such as lead and bismuth.

That is, according to conventional methods for producing low-melting glass, it was not possible to produce a glass, in which softening temperature is 350°C or lower, in which optical characteristics, particularly Abbe number, are stable to temperature change, and which has high transparency concurrently in an ultraviolet-visible region. Even materials other than glass did not satisfy such characteristics. Furthermore, hitherto, there has been no glass, in which softening temperature is 350°C or lower, particularly 100°C or lower, in which change of Abbe number does not exceed 1.5 in a temperature range of 20-150°C (a difference between the maximum value and the minimum value is 1.5 or less), in which a standard deviation of Abbe number in a temperature range of 20-150°C is 0.5 or less, and in which an average transmittance in a wavelength range of 300-800nm is 85% or greater, and it has not been possible to easily produce such glass.

According to the present invention, there is provided an organic-inorganic hybrid glassy material characterized in that change of Abbe number does not exceed 1.5 in a temperature range of 20-150°C (a difference between the maximum value and the minimum value is 1.5 or less). This is a first aspect of the present invention.

In the above organic-inorganic hybrid glassy material, transmittance in a wavelength range of 300-800nm may not be lowered by 5% or greater to a laser light irradiation of a wavelength of 330-380nm.
This is a second aspect of the present invention.

### BRIEF DESCRIPTION OF THE DRAWINGS

Fig. 1 is a graph of temperature-Abbe number, shown by Example 1 of the present invention;
Fig. 2 is a graph of temperature-Abbe number, shown by Comparative Example 1 of the present invention;
Fig. 3 is a graph of temperature-Abbe number, shown by Comparative Example 2 of the present invention;
Fig. 4 shows light transmittance curves before and after laser irradiation, shown by Example 4 of the present invention;
Fig. 5 shows light transmittance curves before and after laser irradiation, shown by Comparative Example 5 of the present invention; and
Fig. 6 shows light transmittance curves before and after laser irradiation, shown by Comparative Example 6 of the present invention.

### DETAILED DESCRIPTION

An organic-inorganic hybrid glassy material according to the present invention can be applied to the field, where low-melting glass is used, such as material for sealing and coating for display parts including PDP, material for optical information communication devices including optical switch and optical connector, materials for optical instruments including LED chips, photo-functional (nonlinear) optical material and adhesive material, and to the field where organic material such as epoxy is used. Furthermore, as an optical material in an environment where temperature tends to change, it can also be used as a substitute for a glass or ceramic. Furthermore, it can also be used as a substitute for a glass or ceramic that withstands a long-time use under UV light irradiation.

It is possible by the present invention to produce a low-melting, organic-inorganic hybrid glassy material, in which softening temperature is extremely low, in which Abbe number by temperature is small, and which is usable in particularly optical uses; production of such material has been hitherto considered to be extremely difficult.

Furthermore, it was possible by the present invention to produce a low-melting, organic-inorganic hybrid glassy material, in which softening temperature is 350°C or lower, particularly 100°C or lower, in which transmittance in a visible wavelength region does not lower by 5% or greater to a laser light irradiation of a wavelength of ultraviolet region, and in which visible light transmittance is also high; production of such material has been hitherto considered to be extremely difficult.

In an organic-inorganic hybrid glassy material of the present invention, change of Abbe number in a temperature range of 20-150°C does not become greater than 1.5 (difference between the maximum value and the minimum value is 1.5 or less). Because it cannot be used as an optical material due to no possibility of aberration correction, in case that change of Abbe number becomes greater than 1.5 by temperature change.

Furthermore, in an organic-inorganic hybrid glassy material of the present invention, standard deviation of Abbe number in a temperature range of 20-150°C is 0.5 or less. Because it cannot be used as an optical material due to no possibility of aberration correction, in case that standard deviation of Abbe number is 0.5 or greater.

An organic-inorganic hybrid glassy material of the present invention is characterized in that transmittance in a wavelength range of 300-800n does not lower by 5% or greater to a laser light irradiation of a wavelength of 330-380nm. In case that transmittance in a wavelength range of 300-800nm lowers by 5% or greater by the laser light irradiation, increase of transmission loss or coloring occurs. In order to use it as an optical component for ultraviolet-visible light, lowering of transmittance in a wavelength range of 300-800nm by laser light irradiation is preferably 5% or less.

Furthermore, the average transmittance in a wavelength range of 300-800nm is 85% or greater. In case that the average transmittance in a wavelength range of 300-800nm, particularly 300-380nm, is 85% or less, the organic group is decomposed to generate increase of transmission loss or coloring in visible light region by energy of the absorbed ultraviolet light or thermal energy generated thereby. In order to use it as an optical component for ultraviolet-visible light, the average transmittance in a wavelength of 300-800nm is preferably 85% or greater.

Furthermore, it is preferably an organic-inorganic hybrid glassy material, in which softening temperature is 50°C-350°C, and which has meltability. If softening temperature is lower than 50°C, its chemical stability is problematic. If it exceeds 350°C, workability becomes problematic. Although softening temperature tends to change by its treatment, it is more preferable that the final softening temperature is 100-300°C, moreover 120-280°C. Concurrently, it is necessary to have meltability. It is because no meltability causes many cases to generate a problem in adhesion. Softening temperature was decided from TMA measurement with a temperature increase at 10°C/min. That is, the amount of shrinkage was measured under the above condition, and the temperature at which the amount of shrinkage starts to change was judged as softening temperature.

In the case of producing an organic-inorganic hybrid glassy material, it is desirable that the production is conducted by a concentration of a raw material having meltability, a melting, then a heating treatment under reduced pressure, and then a high-temperature thermal treatment at 300°C or higher. It is necessary that the raw material prior to the heat treatment has meltability. Herein, meltability refers literally to a characteristic to melt, that is, a characteristic that viscosity lowers greatly by heating to become a so-called melted condition. It is because neither softening nor melting is possible without this meltability. It is preferable to conduct the high-temperature thermal treatment, which is conducted after the melting and the heating under reduced pressure of the raw material, at a temperature of 300°C or higher. Main object of melting is to homogenize the raw material, that of the heating under reduced pressure is to slowly conduct a structural change of the entirety of the raw material, and that of the subsequent high-temperature thermal treatment is the change of a particular bond. The reason why the high-temperature thermal treatment temperature has been set at 300°C or higher is that a high-temperature thermal treatment temperature of 300°C or lower requires a long time and therefore has small merit in industry such as productivity. If the high-temperature thermal treatment temperature is from 300°C to 400°C, it is preferable to conduct a thermal treatment for 30 minutes to 3 hours. Furthermore, if the high-temperature thermal treatment temperature is from 400°C to 550°C, it is preferable to conduct a thermal treatment for 30 minutes or shorter.

It is preferable that the raw material having meltability contains phenyl group. It is important that a metal unit having an organic functional group R, such as a silicon unit represented by (RₙSiO_{(4-n)/2}) (n is selected from 1, 2 and 3), is mixed into the structure of the organic-inorganic hybrid glassy material. This silicon unit is represented by a metal unit of phenyl group (PhₙSiO_{(4-n)/2}), a metal unit of methyl group (MeₙSiO_{(4-n)/2}), a metal unit of ethyl group (EtₙSiO_{(4-n)/2}), a metal unit of butyl group (BtₙSiO_{(4-n)/2}) (n = 1-3) and the like. The metal unit of phenyl group is the most effective.

It is preferable that the raw material having meltability contains D unit. D unit is one where, in four bonds of a silicon atom, all two or one thereof excluding the bonds with organic substituents is bonded to silicon atom through oxygen atom, and it is desirable to contain that in 15% to 50% of all the silicon units by molar ratio. This is because viscosity upon melting is too high if it is less than 15%, and strength at room temperature becomes insufficient if it is greater than 50%. The content is more desirably from 20% to 45%.

It is preferable to conduct the high-temperature thermal treatment at 300°C to 550°C. A thermal treatment at lower than 300°C requires an extremely long time. Therefore, an industrial merit is almost not recognized. On the other hand, if it exceeds 550°C, the reaction proceeds too rapidly, its control becomes difficult, and a problem of coloring may occur. It is more preferably 400°C to 525°C, still preferably 450°C to 500°C. It is necessary to conduct the thermal treatment for a period of time to the extent that the organic functional group does not decompose. Therefore, for example, in case that the thermal treatment is conducted at 400°C to 550°C, the thermal treatment time is preferably 30 minutes or shorter. If the thermal treatment is conducted in a manner to exceed 30 minutes, the organic functional group may decompose, resulting in no obtainment of a good glassy material. It is more preferably 20 minutes or shorter, still preferably 10 minutes or shorter. For example, in case that the thermal treatment is conducted at 300°C to 400°C, the thermal treatment time is preferably 3 hours or shorter. These conditions become different depending on the required specification of light transmittance, on the kinds of organic functional groups, and on the condition that the coloring is permitted. In many cases, however, they almost become the above-mentioned conditions.

It is preferable to produce the raw material, as follows. That is, the starting raw material is a metal alkoxide. It is preferable to produce the raw material by conducting a mixing step by using a metal alkoxide as the raw material, water, acid catalyst and alcohol, followed by concentration step, melting step, step of heating under reduced pressure, and high-temperature thermal treatment step. According to this process, its stability is also high, and the production is also possible with low cost while maintaining good quality. Herein, an important thing is meltability. The production is not possible by conventional sol-gel processes having no meltability.

The upper limit temperature for the concentration step is 100°C or lower, when an alcohol having a boiling point of higher than 100°C such as 1-butanol having a boiling point of 118°C is used. In the case of an alcohol having a boiling point of not higher than 100°C, it is desirable that the boiling point is also taken into consideration. When, for example, ethanol is used, there is a tendency that a better result is achieved when the temperature is made to be not higher than 80°C, which is its boiling point. That is likely due to the reason that, when the temperature is higher than the boiling point, alcohol suddenly evaporates whereby a homogeneous reaction is hardly achieved due to the changes of alcohol in amount and state.

It is preferable that the melting step is conducted at a temperature of 30°C to 400°C. At a temperature of lower than 30°C, melting is substantially impossible. When it is higher than 400°C, an organic group bonded to a metal element, which forms a network, burns. Therefore, a desired organic-inorganic hybrid glassy material is not obtained. In addition, disintegration takes place or bubbles are formed to give non-transparency. Preferably, it is from 100°C to 300°C.

It is preferable that, in the step of heating under reduced pressure, the treatment is conducted at a temperature of 250°C to 300°C and under a pressure of 0.1Torr or lower. At a temperature of lower than 250°C, it is not possible to sufficiently accelerate the reaction. When it is higher than 300°C, a thermal decomposition may take place and it is difficult to obtain a stable glassy material. If the pressure at this time exceeds 0.1Torr, there occurs a problem of remaining of bubbles. Furthermore, it is necessary that the time required for the heating under reduced pressure is 5 minutes or longer. Although the time for the heating under reduced pressure varies depending upon the treatment amount, the treatment temperature and the allowable residual amount of reactive hydroxyl groups (-OH), it is generally very difficult to achieve a satisfactory level when the time is shorter than 5 minutes. The productivity lowers when it is too long. Accordingly, it is preferably from 10 minutes to one week.

As a result of conducting the above melting step and the step of heating under reduced pressure, a stabilized organic-inorganic hybrid glassy material can be obtained. In conventional sol-gel processes, there is neither the melting step nor the step of heating under reduced pressure, and therefore it is not possible to obtain an organic-inorganic hybrid glassy material of the present invention.

In the melting step by heating or in the step of heating under reduced pressure, to conduct it in an inert atmosphere or microwave heating is also effective.

In conventional so-gel processes, hydrochloric acid or nitric acid has been used as a catalyst in many cases. This was because the gellation time becomes long in the case of other catalysts. In the mixing step of the present invention, nitric acid and other acids are not preferable, but the use of hydrochloric acid or acetic acid is preferable. A more preferable one is acetic acid. Trifluoroacetic acid is also useful.

The metal alkoxide used as the raw material is an alkoxysilane replaced with an organic substituent. It is preferably selected from metal alkoxides where the organic substituent is phenyl group, methyl group, ethyl group, propyl group (n- and i-), butyl group (n-, i- and t-), pentyl group, hexyl group, octyl group, decyl group, dodecyl group, octadecyl group, mercaptomethyl group, mercaptopropyl group, 3,3,3-trifluoropropyl group, 3-trifluoroacetoxypropyl group, vinyl group, benzyl group, styryl group or the like, and where the alkoxyl group is methoxy group, ethoxy group, propoxy group (n- and i-) or the like. These are very useful raw materials for producing an organic-inorganic hybrid glassy material, particularly a transparent material having a low softening of room temperature or lower. Metal alkoxides other than the above-mentioned ones may be used as well. Production is also possible so far as a material that has been used in sol-gel processes, such as metal acetylacetonate, metal carboxylate, metal nitrate, metal hydroxide and metal halide, is used.

With regard to alcohol, the representative ones are methanol, ethanol, 1-propanol, 2-propanol, 1-butanol, 2-methyl-1-propanol, 2-butanol, 1,1-dimethyl-1-ethanol, etc. although it is not limited to these.

It is also effective to use ammonia in the mixing step. Upon this, it is preferable that the ammonia to be used is 1 to 20 times that of hydrochloric acid or acetic acid by molar ratio. Each of ammonia, hydrochloric acid and acetic acid is a catalyst, a combination of ammonia and acetic acid or of ammonia and hydrochloric acid is taken, and ammonia alone does not show a good result. If the ammonia to be used in the mixing step is in an amount less than one time that of hydrochloric acid or acetic acid, the alkoxide is not completely hydrolyzed, and a large amount of T²(-OEt) remains in the glass, thereby generating a problem of inferior chemical stability. On the other hand, if the amount to be used in the mixing step is in an amount larger than 20 times that of hydrochloric acid or acetic acid, the hydrolysis-polycondensation reaction proceeds rapidly, thereby generating a problem of not achieving a homogeneous reaction. More preferably, it is in a range of 2-10.

Furthermore, in this case, after the melting step, it is preferable to remove the ammonium salt through a pulverization/washing step. If an ammonium salt exists, a stable organic-inorganic hybrid glassy material may not be obtained.

Although all of the organic-inorganic hybrid glassy materials produced by the above process are naturally targets, it is an organic-inorganic hybrid glassy material that is partially or completely formed with a random network structure.

In the following, the present invention is described in detail based on Examples. The following Examples 1-3 relate to the first aspect of the present invention. Comparative Examples 1-2 are in contrast with Examples 1-3. Examples 4-5 relate to the second aspect of the present invention. Comparative Examples 3-6 are in contrast with Examples 4-5.

### EXAMPLE 1

As starting materials, there were used metal alkoxides, phenyltriethoxysilane (PhSi(OEt)₃) and diethoxydiphenylsilane (Ph₂Si(OEt)₂). As the mixing step, a catalyst, acetic acid, was added at room temperature to phenyltriethoxysilane in 10ml, water in 45ml, and ethanol in 20ml. As the heating reaction step, stirring was conducted at 60°C for 1 hour. Then, 3ml of diethoxydiphenylsilane was added, followed by stirring at 60°C for 2 hours. Then, melting was conducted at 150°C by spending 5 hours, followed by heating under reduced pressure at 250°C for 1hr and then cooling to room temperature, thereby obtaining a so-called raw material that was transparent. Furthermore, this raw material was subjected to a high-temperature thermal treatment at 400°C for 5 minutes, thereby obtaining a transparent material having a thickness of 1mm.

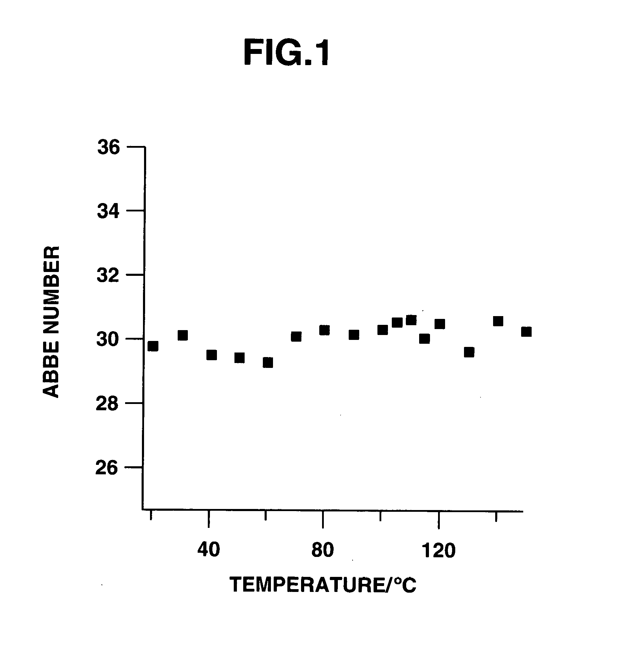

Refractive index of the transparent material was measured by Model 2010 Prism Coupler (Metricon) at different wavelengths (473, 632.8, 1319, and 1553nm). Using the measured values of refractive index, a refractive index-wavelength approximate curve was prepared from an approximate formula of Cauchy. Abbe number was calculated from refractive indexes n_{F}, n_{D} and nc of 486, 589 and 656nm on the approximate curve. Furthermore, Abbe numbers were similarly determined by changing the temperature of the transparent material to 20-150°C. The change of Abbe number of this transparent material in 20-150°C is shown in Fig. 1. The change of Abbe number by the temperature change was 1.3 (difference between the maximum value and the minimum value was 1.3), which was not greater than 1.5.

Standard deviation of Abbe number in 20-150°C was 0.4, which was not greater than 0.5.

The average transmittance of this transparent material in a wavelength range of 300-800nm was determined by a Hitachi U3500 type automatic recording spectrophotometer. With this, it was 89.3%, which was not less than 85%.

Softening temperature of this transparent material was 124 °C, which was a temperature lower than about 500 °C of the decomposition temperature of phenyl group.

Softening temperature of the organic-inorganic hybrid glassy material was judged from TMA measurement, in which the temperature was increased at 10°C/min. That is, softening behavior was determined from the change of the amount of shrinkage under the above condition, and its starting temperature was defined as softening temperature.

Furthermore, when the bonding condition of this transparent material was measured by a CMX-400 type magnetic resonance measurement apparatus of JEOL Company, the concentration of D unit has not changed after the thermal treatment of 400 °C. With this, it was confirmed that D unit existed with no disappearance even after the high-temperature thermal treatment. In view of the fact that it was possible to confirm the random network structure, the transparent material prepared in this time is a material having an organic-inorganic hybrid glass structure, that is, an organic-inorganic hybrid glassy material.

### EXAMPLE 2

Raw materials almost similar to and steps similar to those of Example 1 were used, but a high-temperature thermal treatment was conducted at 300°C for 2 hours, thereby obtaining a transparent material having a thickness of 1mm.

Similar to Example 1, the change of Abbe number of this transparent material due to the temperature change was determined. With this, it was 1.2 (difference between the maximum value and the minimum value was 1.2), which was not greater than 1.5.

Standard deviation of Abbe number in 20-150°C was 0.4, which was not greater than 0.5.

The average transmittance of this transparent material in a wavelength range of 300-800nm was determined. With this, it was 89.2%, which was not less than 85%.

Softening temperature of this transparent material was 150°C, which was a temperature lower than about 500°C of the decomposition temperature of phenyl group.

Furthermore, when the bonding condition of this transparent material was measured by a CMX-400 type magnetic resonance measurement apparatus of JEOL Company, the concentration of D unit has not changed after the thermal treatment of 300 °C. With this, it was confirmed that D unit existed with no disappearance even after the high-temperature thermal treatment. In view of the fact that it was possible to confirm the random network structure, the transparent material prepared in this time is a material having an organic-inorganic hybrid glass structure, that is, an organic-inorganic hybrid glassy material.

### EXAMPLE 3

Raw materials almost similar to and steps similar to those of Example 1 were used, but a transparent material having a thickness of 1mm was obtained without conducting the high-temperature thermal treatment.

Similar to Example 1, the change of Abbe number of this transparent material due to the temperature change was determined. With this, it was 1.3 (difference between the maximum value and the minimum value was 1.3), which was not greater than 1.5.

Standard deviation of Abbe number in 20-150°C was 0.4, which was not greater than 0.5.

The average transmittance of this transparent material in a wavelength range of 300-800nm was determined. With this, it was 89.0%, which was not less than 85%.

Softening temperature of this transparent material was 156°C, which was a temperature lower than about 500°C of the decomposition temperature of phenyl group.

Furthermore, when the bonding condition of this transparent material was measured by a CMX-400 type magnetic resonance measurement apparatus of JEOL Company, the concentration of D unit has not changed after the heating under reduced pressure of 250 °C. With this, it was confirmed that D unit existed with no disappearance even after the heating under reduced pressure. In view of the fact that it was possible to confirm the random network structure, the transparent material prepared in this time is a material having an organic-inorganic hybrid glass structure, that is, an organic-inorganic hybrid glassy material.

### (COMPARATIVE EXAMPLE 1)

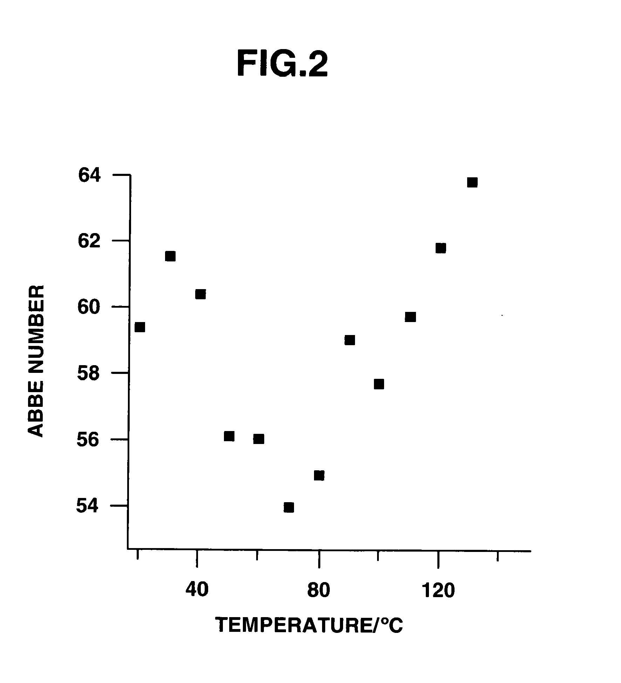

Similar to Example 1, Abbe number was determined by using an acrylic resin board having a thickness of 1mm. The change of Abbe number of the acrylic resin in 20-150°C is shown in Fig. 2. The change of Abbe number due to the temperature change was 9.7 (difference between the maximum value and the minimum value was 9.7), which was greater than 1.5.

Standard deviation of Abbe number in 20-150°C was 2.9, which was not less than 0.5.

The average transmittance of the acrylic resin in a wavelength range of 300-800nm was determined. With this, it was 87.4%, which was not less than 85%.

### (COMPARATIVE EXAMPLE 2)

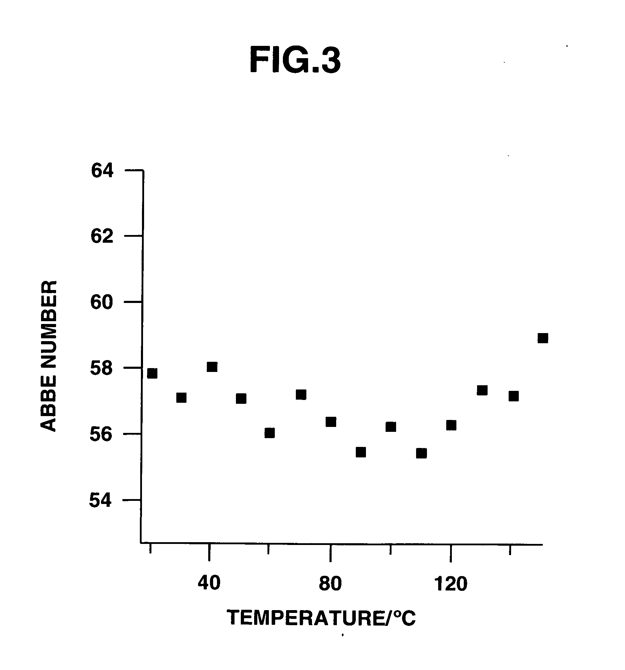

Similar to Example 1, Abbe number was determined by using an epoxy resin board having a thickness of 1mm. The change of Abbe number of the epoxy resin in 20-150°C is shown in Fig. 3. The change of Abbe number due to the temperature change was 3.5 (difference between the maximum value and the minimum value was 3.5), which was greater than 1.5.

Standard deviation of Abbe number in 20-150°C was 1.0, which was not less than 0.5.

The average transmittance of the epoxy resin in a wavelength range of 300-800nm was determined. With this, it was 75.7%, which was not greater than 85%.

### EXAMPLE 4

A transparent material having a thickness of 1mm was obtained by the same method as that of Example 1.

This transparent material was irradiated with a laser light at 25°C for 1hr by using a YAG laser PL2143AX(EKSPLA, Lithuania) of a wavelength of 355nm. Pulse duration was 27ps, pulse repetition rate was 10Hz, and energy density was 180mJ/cm².

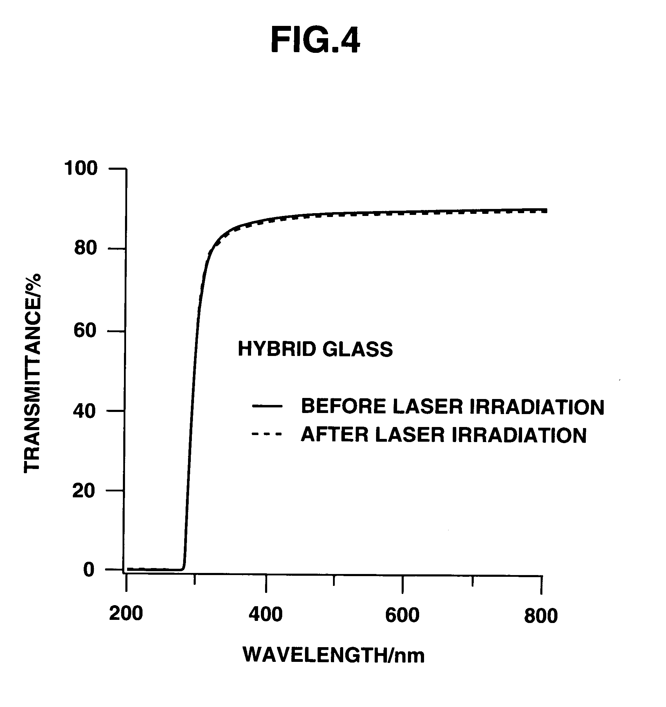

In Fig. 4, there are shown the results obtained by measuring light transmittances of this transparent material in 200-800nm before and after the laser irradiation by a Hitachi U3500 type automatic recording spectrophotometer. Transmittance in a wavelength of 300-800nm did almost not change by the laser irradiation. Its lowering percentage was 0.4%, which was not greater than 5%.

The average transmittance of this transparent material in a wavelength range of 300-380nm before the laser irradiation was 87.6%, which was not less than 85%.

### EXAMPLE 5

A transparent material having a thickness of 1mm was obtained by the same method as that of Example 2.

Similar to Example 4, this transparent material was irradiated with the laser light, and transmittances in a wavelength range of 300-800nm were measured before and after that. With this, it did almost not change, and its lowering percentage was 0.5%, which was not greater than 5%.

The average transmittance of this transparent material in a wavelength range of 300-380nm before the laser irradiation was 88.2%, which was not less than 85%.

### (COMPARATIVE EXAMPLE 3)

Except in that a high-temperature thermal treatment was conducted at 600°C, raw materials and steps that were the same as those of Example 1 were used, thereby obtaining a yellow transparent material having a thickness of 1mm. Similar to Example 4, this yellow transparent material was irradiated with a laser light. With this, a brown, irradiation mark was observed at the irradiated part. Transmittances in a wavelength range of 300-800nm before and after the laser irradiation were measured. With this, the lowering percentage was 15.5%, which was not less than 5%.

The average transmittance of this yellow transparent material in a wavelength range of 300-380nm before the laser irradiation was 65.5%, which was not greater than 85%.

When the bonding condition of this yellow transparent material was measured by a CMX-400 type magnetic resonance measurement apparatus of JEOL Company, the concentration of D unit lowered after a thermal treatment of 600°C. With this, it was confirmed that a part of D unit had disappeared by the high-temperature thermal treatment.

### (COMPARATIVE EXAMPLE 4)

When a laser light irradiation was conducted similar to Example 4 by using an acrylic resin board having a thickness of 1mm, a pale-yellow irradiation mark was observed at the irradiation part. When transmittances in a wavelength region of 300-800nm before and after the laser irradiation were measured, the lowering percentage was 5.8%, which was not less than 5%.

The average transmittance of the acrylic resin board in a wavelength range of 300-380nm before the laser irradiation was 22.2%, which was not greater than 85%.

### (COMPARATIVE EXAMPLE 5)

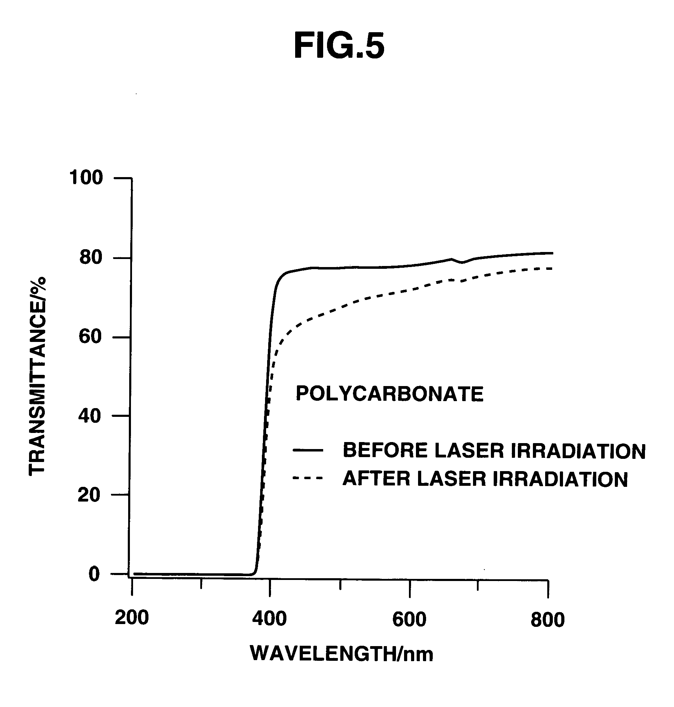

When a laser light irradiation was conducted similar to Example 4 by using a polycarbonate resin board having a thickness of 1mm, a brown irradiation mark was observed at the irradiation part. When transmittances in a wavelength region of 300-800nm before and after the laser irradiation were measured, the lowering percentage was 6.3%, which was not less than 5%. In Fig. 5, there are shown the results obtained by measuring light transmittances of the polycarbonate resin board in 200-800nm before and after the laser irradiation.

The average transmittance of the polycarbonate resin board in a wavelength range of 300-380nm before the laser irradiation was not greater than 0.1%, which was not greater than 85%.

### (COMPARATIVE EXAMPLE 6)

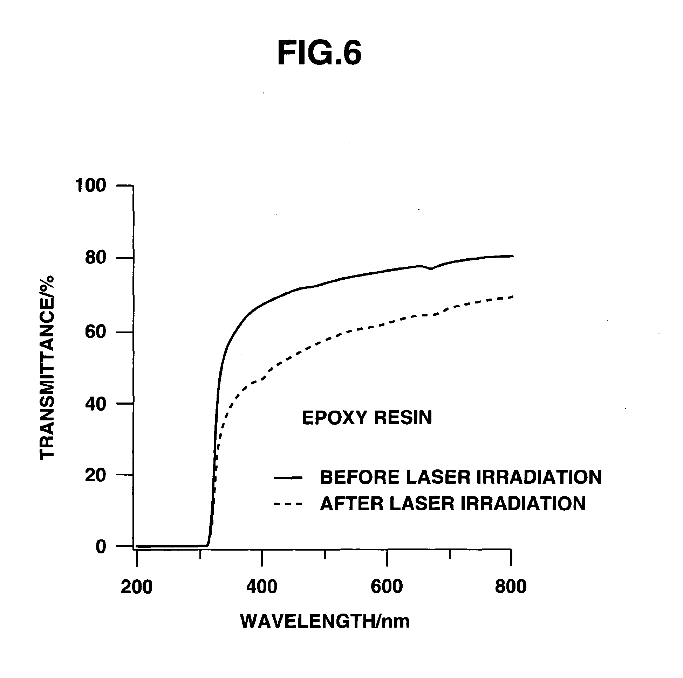

When a laser light irradiation was conducted similar to Example 4 by using an epoxy resin board having a thickness of 1mm, a brown irradiation mark was observed at the irradiation part. When transmittances in a wavelength region of 300-800nm before and after the laser irradiation were measured, the lowering percentage was 14.5%, which was not less than 5%. In Fig. 6, there are shown the results obtained by measuring light transmittances of the polycarbonate resin board in 200-800nm before and after the laser irradiation.

The average transmittance of the epoxy resin board in a wavelength range of 300-380nm before the laser irradiation was 40.9%, which was not greater than 85%.

## Claims

1. An organic-inorganic hybrid glassy material **characterized in that** change of Abbe number does not exceed 1.5 in a temperature range of 20-150°C (a difference between the maximum value and the minimum value is 1.5 or less).

2. An organic-inorganic hybrid glassy material according to claim 1, which is **characterized in that** standard deviation of Abbe number in a temperature range of 20-150°C is 0.5 or less.

3. An organic-inorganic hybrid glassy material according to claim 1 or claim 2, which is **characterized in that** transmittance in a wavelength range of 300-800nm is not lowered by 5% or greater to a laser light irradiation of a wavelength of 330-380nm.

4. An organic-inorganic hybrid glassy material according to any one of claims 1 to 3, which is **characterized in that** an average transmittance in a wavelength range of 300-800nm is 85% or greater.

5. An organic-inorganic hybrid glassy material according to any one of claims 1 to 4, which is **characterized in that** softening temperature is 50°C-350°C and that it has meltability.

6. An organic-inorganic hybrid glassy material according to any one of claims 1 to 5, which is **characterized in that** the glassy material is partially or completely formed with a random network structure.

7. An organic-inorganic hybrid glassy material according to any one of claims 1 to 6, which is **characterized** that it contains a phenyl group.
